# EUROPÄISCHE PATENTSCHRIFT

(11) **EP 2 324 501 B1**
(45) Veröffentlichungstag und Bekanntmachung des Hinweises auf die Patenterteilung: **21.11.2018**
(21) Anmeldenummer: 09776075.5
(22) Anmeldetag: 07.08.2009
(51) Int. Cl.: H01L 25/075, H01L 33/44, H01L 33/54, H01L 33/58

(54) **LEUCHTMITTEL MIT DREI GRUPPEN VON HALBLEITERCHIPS**
ILLUMINATION MEANS COMPRISING THREE GROUPS OF SEMICONDUCTOR CHIPS
MOYEN D'ÉCLAIRAGE COMPRENANT TROIS GROUPES DE PUCES SEMI-CONDUCTRICES

(30) Priorität: 17.09.2008 DE 102008047579
(43) Veröffentlichungstag der Anmeldung: 25.05.2011
(73) Patentinhaber: OSRAM Opto Semiconductors GmbH, 93055 Regensburg (DE)
(72) Erfinder: EISSLER, Dieter, 201702 Qing Pu Shanghai (CN); HERRMANN, Siegfried, 94362 Neukirchen (DE)
(74) Vertreter: Epping - Hermann - Fischer
(86) Internationale Anmeldenummer: PCT/DE2009/001122
(87) Internationale Veröffentlichungsnummer: WO 2010/031367

(56) Entgegenhaltungen:
- EP-A2- 1 968 115
- WO-A1-2008/038915
- WO-A1-2008/056292
- WO-A2-97/23912
- JP-A- 2000 244 020
- US-A1- 2007 018 189
- US-A1- 2007 177 648

## Beschreibung

Es wird ein Leuchtmittel angegeben.

Optoelektronische Bauteile, wie zum Beispiel Leucht- oder Laserdioden, haben eine breite technische Anwendung gefunden. Einige Gesichtspunkte, die der Verbreitung solcher Bauteile Vorschub leisteten, sind etwa deren hohe Effizienz und Widerstandsfähigkeit gegen äußere Belastungen sowie Umwelteinflüsse. Auch weisen optoelektronische Bauteile eine hohe Lebensdauer auf. Optoelektronische Bauteile basieren häufig auf Halbleiterchips, die in einem bestimmten, meist schmalen Spektralbereich Strahlung emittieren.

Die Druckschriften JP 2000-244020 A und WO 2008/038915 A1 offenbaren jeweils eine lichtemittierende Vorrichtung mit mehreren LEDs, die in verschiedenen Ebenen angeordnet sein können.

Die Druckschrift WO 2008/056292 A1 beschreibt eine lichtemittierende Vorrichtung mit LED-Chips, die nebeneinander angeordnet und von einem Konversionselement bedeckt sind.

Die Druckschrift US 2007/0018189 A1 beschreibt ein Leuchtmittel, bei dem mehrere LED-Chips übereinander angeordnet sind.

Eine zu lösende Aufgabe besteht darin, ein Leuchtmittel anzugeben, das bezüglich Intensität und Farbe eine homogene Abstrahlung aufzeigt.

Erfindungsgemäß weist das Leuchtmittel eine erste Gruppe von Halbleiterchips auf. Die erste Gruppe umfasst mindestens einen Halbleiterchip, bevorzugt mehrere Halbleiterchips. Die Halbleiterchips sind dazu gestaltet, im Betrieb elektromagnetische Strahlung, insbesondere im sichtbaren Spektralbereich, zu emittieren.

Erfindungsgemäß umfasst das Leuchtmittel eine zweite Gruppe von Halbleiterchips, die mindestens einen Halbleiterchip, bevorzugt mehrere Halbleiterchips, aufweist. Auch die Halbleiterchips der zweiten Gruppe sind dazu gestaltet, im Betrieb elektromagnetische Strahlung, insbesondere im sichtbaren Spektralbereich, zu emittieren.

Erfindungsgemäß weist das Leuchtmittel mindestens eine Hauptabstrahlrichtung auf. Zum Beispiel ist die Hauptabstrahlrichtung diejenige Richtung, in der das Leuchtmittel die höchste Strahlungsleistung emittiert. Ist das Leuchtmittel flächig und/oder eben ausgestaltet, so ist die Hauptabstrahlrichtung bevorzugt senkrecht zu einer Oberfläche des Leuchtmittels ausgerichtet. Insbesondere ist die Hauptabstrahlrichtung parallel zu einer Wachstumsrichtung einer epitaktischen Schichtenfolge, etwa eines Halbleiterchips des Leuchtmittels, orientiert. Das Leuchtmittel kann auch zwei Hauptabstrahlrichtungen aufweisen, die in entgegengesetzte Richtungen weisen.

Erfindungsgemäß ist wenigstens ein Teil der Halbleiterchips der zweiten Gruppe bezüglich der Hauptabstrahlrichtung lateral neben Halbleiterchips der ersten Gruppe angeordnet. Beispielsweise sind die Halbleiterchips der ersten Gruppe und der zweiten Gruppe in einer Ebene, insbesondere senkrecht zur Hauptabstrahlrichtung, angeordnet. Die Halbleiterchips der ersten und der zweiten Gruppe können auf einer einzigen, insbesondere eben gestalteten Montagefläche aufgebracht sein.

Erfindungsgemäß beinhaltet das Leuchtmittel eine dritte Gruppe von Halbleiterchips, wobei die dritte Gruppe mindestens einen Halbleiterchip, insbesondere mehrere Halbleiterchips, umfasst. Die Halbleiterchips der dritten Gruppe sind ebenfalls dazu ausgestaltet, elektromagnetische Strahlung zu emittieren, bevorzugt im blauen Spektralbereich.

Erfindungsgemäß sind die Halbleiterchips der dritten Gruppe bezüglich der Hauptabstrahlrichtung den Halbleiterchips der ersten und der zweiten Gruppe vollständig nachgeordnet. Mit anderen Worten gibt die Hauptabstrahlrichtung eine Richtung vor, und bezüglich dieser Richtung folgen die Halbleiterchips der dritten Gruppe denen der ersten und zweiten Gruppe nach. Beispielsweise sind die Halbleiterchips der dritten Gruppe vertikal über den Halbleiterchips der ersten und der zweiten Gruppe angeordnet.

Erfindungsgemäß sind die Halbleiterchips jeder Gruppe dazu ausgestaltet, in paarweise voneinander verschiedenen Wellenlängenbereichen zu emittieren.

Erfindungsgemäß ist die von den Halbleiterchips der dritten Gruppe emittierte Strahlung diejenige Strahlung, die den kurzwelligsten Wellenlängenbereich aufweist. Beispielsweise emittieren die Halbleiterchips der ersten Gruppe im roten Spektralbereich, die Halbleiterchips der zweiten Gruppe im grünen Spektralbereich und die Halbleiterchips der dritten Gruppe im blauen Spektralbereich.

Erfindungsgemäß gelangt die von den Halbleiterchips der ersten und der zweiten Gruppe emittierte Strahlung wenigstens teilweise in mindestens einen Halbleiterchip der dritten Gruppe. Mit anderen Worten sind die Halbleiterchips der dritten Gruppe den Halbleiterchips der ersten und der zweiten Gruppe optisch nachgeordnet. Das heißt, die von den Halbleiterchips der ersten und der zweiten Gruppe erzeugte Strahlung durchstrahlt den mindestens einen Halbleiterchip der dritten Gruppe.

Erfindungsgemäß weist das Leuchtmittel eine Abstrahlfläche auf, von der eine Mischstrahlung emittiert wird. Bevorzugt ist die Mischstrahlung weißes Licht.

Erfindungsgemäß weist das Leuchtmittel eine erste Gruppe von Halbleiterchips und eine zweite Gruppe von Halbleiterchips auf, wobei die Gruppen jeweils mindestens einen Halbleiterchip umfassen und die erste und die zweite Gruppe von Halbleiterchips wenigstens zum Teil bezüglich einer Hauptabstrahlrichtung des Leuchtmittels lateral nebeneinander angeordnet sind. Weiterhin umfasst das Leuchtmittel eine dritte Gruppe von Halbleiterchips, die mindestens einen Halbleiterchip beinhaltet und wobei die dritte Gruppe bezüglich der Hauptabstrahlrichtung der ersten und der zweiten Gruppe nachgeordnet ist. Jede Gruppe von Halbleiterchips ist dazu ausgestaltet, in paarweise voneinander verschiedenen Wellenlängenbereichen elektromagnetische Strahlung, insbesondere im sichtbaren Spektralbereich, zu emittieren. Die von der dritten Gruppe von Halbleiterchips emittierte Strahlung weist hierbei den kurzwelligsten Wellenlängenbereich auf. Die von der ersten und zweiten Gruppe von Halbleiterchips emittierte Strahlung gelangt wenigstens teilweise in den wenigstens einen Halbleiterchip der dritten Gruppe. Über eine Abstrahlfläche des Leuchtmittels wird eine Mischstrahlung emittiert.

Ein solches Leuchtmittel kann, bezüglich Intensität und Farbe, eine homogene Mischstrahlung emittieren. Dies wird unter anderem dadurch gewährleistet, dass sich die von der ersten und zweiten Gruppe von Halbleiterchips emittierte Strahlung im mindestens einen Halbleiterchip der dritten Gruppe mit der Strahlung dieses Halbleiterchips mischt.

Gemäß zumindest einer Ausführungsform des Leuchtmittels sind die verschiedenen Halbleiterchips der einzelnen Gruppen nicht monolithisch integriert. Mit anderen Worten sind die Halbleiterchips der ersten, zweiten und dritten Gruppe paarweise separat gefertigt. Die in verschiedenen Spektralbereichen emittierenden Halbleiterchips sind zum Beispiel nicht direkt aufeinander aufgewachsen. Im Leuchtmittel sind also mehrere, separat gefertigte Halbleiterchips zu einer Anordnung zusammengefügt beziehungsweise arrangiert.

Gemäß zumindest einer Ausführungsform des Leuchtmittels ist eine Hauptfläche mindestens eines Halbleiterchips der dritten Gruppe größer als eine Hauptfläche mindestens eines Halbleiterchips der ersten und mindestens eines Halbleiterchips der zweiten Gruppe. Eine Hauptfläche ist etwa eine solche Fläche, die einen Halbleiterchip in einer Richtung parallel zu einer Epitaxiewachstumsrichtung begrenzt. Eine Hauptfläche stellt bevorzugt eine Strahlungsaustrittsfläche eines Halbleiterchips dar. Der mindestens eine Halbleiterchip der dritten Gruppe weist insbesondere eine Hauptfläche auf, die größer ist als eine Hauptfläche sämtlicher Halbleiterchips der ersten und der zweiten Gruppe. Der mindestens eine Halbleiterchip der dritten Gruppe kann die Halbleiterchips der ersten und zweiten Gruppe in Richtung der Hauptabstrahlrichtung vollständig überdecken. Das heißt, werden die Hauptflächen der Halbleiterchips auf eine Ebene senkrecht zur Hauptabstrahlrichtung projiziert, so umfasst die projizierte Hauptfläche des mindestens einen Halbleiterchips der dritten Gruppe die projizierten Hauptflächen der Halbleiterchips der ersten und der zweiten Gruppe vollständig.

Gemäß zumindest einer Ausführungsform des Leuchtmittels sind die Hauptflächen aller Halbleiterchips senkrecht zur Hauptabstrahlrichtung orientiert. Die Hauptabstrahlrichtung bildet also eine Normale bezüglich der Hauptflächen der Halbleiterchips.

Gemäß zumindest einer Ausführungsform des Leuchtmittels umfasst die dritte Gruppe genau einen Halbleiterchip, dessen Hauptfläche größer ist als die Summe der Hauptflächen aller Halbleiterchips der ersten und zweiten Gruppe. Der Halbleiterchip der dritten Gruppe kann zudem alle anderen Halbeiterchips vollständig überdecken.

Gemäß zumindest einer Ausführungsform des Leuchtmittels weist mindestens ein Halbleiterchip eine Dicke auf, die kleiner oder gleich 20 µm ist. Bevorzugt ist die Dicke mindestens eines Halbleiterchips kleiner oder gleich 15 µm, insbesondere kleiner oder gleich 10 µm. Bevorzugt weisen mindestens die Halbleiterchips einer Gruppe, insbesondere alle Halbleiterchips aller Gruppen des Leuchtmittels eine solche Dicke auf. Die Halbleiterchips können zum Beispiel als Dünnfilmchips ausgeformt sein, wie in der Druckschrift WO 2005/081319 A1 beschrieben, oder als substratlose Dünnfilmchips, wie in der Druckschrift DE 10 2007 004 304 A1 angegeben.

Gemäß zumindest einer Ausführungsform des Leuchtmittels ist jede Gruppe von Halbleiterchips elektrisch einzeln ansteuerbar. Da die einzelnen Gruppen in verschiedenen Farben emittieren, kann zum Beispiel die Farbe beziehungsweise der Farbort der vom Leuchtmittel emittierten Mischstrahlung über einen weiten Bereich eingestellt werden.

Gemäß zumindest einer Ausführungsform des Leuchtmittels sind die Halbleiterchips einzeln ansteuerbar. Das heißt, jeder Halbleiterchip ist unabhängig von den anderen Halbleiterchips elektrisch bestrombar. Beispielsweise sind die Halbleiterchips elektrisch parallel geschaltet. Weist insbesondere die erste und zweite Gruppe eine Vielzahl von Halbleiterchips auf, so ermöglicht eine derartige elektrische Verschaltung der Halbleiterchips es, die vom Leuchtmittel emittierte Mischstrahlung auch in bestimmten Teilbereichen des Leuchtmittels gezielt einzustellen.

Gemäß zumindest einer Ausführungsform des Leuchtmittels weist dieses ein optisches Element auf, das optisch zwischen den Halbleiterchips der ersten und zweiten Gruppe und den Halbleiterchips der dritten Gruppe angeordnet ist. Mit anderen Worten gelangt, wenigstens teilweise, die von den Halbleiterchips der ersten und zweiten Gruppe emittierte Strahlung durch das optische Element zur dritten Gruppe. Das optische Element kann refraktiv und/oder reflexiv wirken und als Vollkörper gestaltet sein. Bevorzugt wirkt das optische Element, mindestens stellenweise, totalreflektierend. Das optische Element reflektiert insbesondere an Begrenzungsflächen, die parallel oder in einem spitzen Winkel zur Hauptabstrahlrichtung orientiert sind.

Gemäß zumindest einer Ausführungsform des Leuchtmittels ist das optische Element prismenartig oder pyramidenstumpfartig gestaltet. Ebenso ist es möglich, dass das optische Element kegelstumpfartig gestaltet ist. Ein Leuchtmittel mit einem solchen optischen Element kann in einer Richtung parallel zur Hauptabstrahlrichtung besonders Platz sparend aufgebaut sein.

Gemäß zumindest einer Ausführungsform des Leuchtmittels ist eine Höhe des optischen Elements, in Richtung der Hauptabstrahlrichtung, sehr viel kleiner als eine Breite des optischen Elements, in einer Richtung senkrecht zur Hauptabstrahlrichtung. Bevorzugt ist das Verhältnis von Breite zu Höhe größer als 100, insbesondere größer als 1000. Durch die Verwendung eines solchen optischen Elements kann ein großflächig abstrahlendes und dabei sehr flaches Leuchtmittel aufgebaut werden.

Gemäß zumindest einer Ausführungsform des Leuchtmittels sind die Halbleiterchips der ersten Gruppe und der zweiten Gruppe wenigstens teilweise direkt am optischen Element angebracht. Ist das optische Element pyramidenstumpfartig oder kegelstumpfartig gestaltet, so befinden sich die Halbleiterchips der ersten und der zweiten Gruppe bevorzugt an einer eine Basis bildenden Fläche des optischen Elements, also zum Beispiel an der größten, zusammenhängenden Fläche des optischen Elements.

Gemäß zumindest einer Ausführungsform des Leuchtmittels ist zumindest ein Halbleiterchip der ersten Gruppe und zumindest ein Halbleiterchip der zweiten Gruppe als Flip-Chip gestaltet. Das heißt, die elektrischen Kontakte des Halbleiterchips befinden sich auf einer einzigen Hauptfläche. Zudem ist zumindest ein Halbleiterchip der dritten Gruppe so gestaltet, dass sich dessen elektrische Kontakte auf einander gegenüberliegenden Hauptflächen befinden.

Gemäß zumindest einer Ausführungsform des Leuchtmittels, bei dem die dritte Gruppe mindestens zwei Halbleiterchips umfasst, sind diese Halbleiterchips in Richtung der Hauptabstrahlrichtung voneinander beabstandet. Durch diese voneinander beabstandeten Halbleiterchips werden, senkrecht zur Hauptabstrahlrichtung, zwei Ebenen aufgespannt. Diese Ebenen definieren einen sich zwischen den Ebenen befindenden Zwischenraum. In diesem Zwischenraum sind die Halbleiterchips der ersten und der zweiten Gruppe angeordnet.

Gemäß zumindest einer Ausführungsform des Leuchtmittels ist dieses dazu ausgestaltet, die Mischstrahlung an einander gegenüberliegenden Abstrahlflächen des Leuchtmittels zu emittieren. Mit anderen Worten emittiert das Leuchtmittel an zwei einander gegenüberliegenden Seiten die Mischstrahlung. Das Leuchtmittel weist also zwei in entgegengesetzte Richtungen zeigende Hauptabstrahlrichtungen auf. Bei einem solchen Leuchtmittel befinden sich die Halbleiterchips der ersten und zweiten Gruppe zum Beispiel zwischen den Halbleiterchips der dritten Gruppe. Es ist also ein beidseitig abstrahlendes Leuchtmittel realisierbar.

In einer nicht erfindungsgemäßen Abwandlung des Leuchtmittels durchläuft ein Teil der von der ersten Gruppe und der zweiten Gruppe emittierten Strahlung vor dem Verlassen des Leuchtmittels die Halbleiterchips der dritten Gruppe nicht. Ein Teil der von der ersten und zweiten Gruppe emittierten Strahlung ist also an den Halbleiterchips der dritten Gruppe lateral vorbeigeführt. Insbesondere durchläuft ein Teil der Strahlung, der über die Abstrahlfläche des Leuchtmittels dieses verlässt, die Halbleiterchips der dritten Gruppe nicht. Der Leistungsanteil der Strahlung, die von den Halbleiterchips der ersten und zweiten Gruppe emittiert wird, die an den Halbleiterchips der dritten Gruppe vorbeigeführt wird, beträgt bevorzugt zwischen 1 % und 25 %, insbesondere zwischen 5 % und 15 %. Hierdurch erweitert sich ein Bereich des einstellbaren Farborts in der CIE-Normfarbtafel der vom Leuchtmittel emittierten Mischstrahlung, besonders im Grünen und Roten.

Gemäß zumindest einer Ausführungsform des Leuchtmittels, bei dem die erste und die zweite Gruppe jeweils mindestens zwei Halbleiterchips umfasst, sind wenigstens ein Halbleiterchip der ersten Gruppe und wenigstens ein Halbleiterchip der zweiten Gruppe bezüglich der Hauptabstrahlrichtung übereinander angeordnet. Mit anderen Worten überdeckt, bezüglich der Hauptabstrahlrichtung, einer der Halbleiterchips der einen Gruppe einen Halbleiterchip der anderen Gruppe. Die sich überdeckenden Halbleiterchips können in direktem Kontakt zueinander stehen. Durch eine solche Anordnung kann eine besonders homogene Abstrahlung der Mischstrahlung erzielt werden, da eine Mischung der von den Halbleiterchips der ersten und zweiten Gruppe erzeugten Strahlung bereits, mindestens zum Teil, in diesen Halbleiterchips erfolgt und somit eine vergleichsweise homogene Strahlung zu dem mindestens einen Halbleiterchip der dritten Gruppe gelangt.

Gemäß zumindest einer Ausführungsform des Leuchtmittels weist mindestens ein Halbleiterchip prismenartige Mikrostrukturen auf. Bevorzugt weisen alle Halbleiterchips der ersten und der zweiten Gruppe solche Strukturen auf. Die prismenartigen Strukturen sind bevorzugt an genau einer Hauptfläche des Halbleiterchips aufgebracht. Vom Halbleiterchip emittierte Strahlung wird an den Mikrostrukturen, mindestens teilweise, zum Beispiel über Totalreflexion umgelenkt, so dass eine Hauptabstrahlrichtung des Halbleiterchips, bedingt durch die Mikrostrukturen, in einer Richtung parallel zur Hauptseite des Halbleiterchips liegen kann. Die Mikrostrukturen können mit einem Halbleitermaterial oder mit einem Dielektrikum, das in einer Schicht auf dem Halbleiterchip aufgebracht ist, gefertigt sein.

Gemäß zumindest einer Ausführungsform des Leuchtmittels weicht ein Farbort einer lokal an der Abstrahlfläche emittierten Mischstrahlung in der CIE-Normfarbtafel um höchsten 0,02 von einem Mittelwert des Farborts der Mischstrahlung, gemittelt über die gesamte Abstrahlfläche, ab. Bevorzugt beträgt die Abweichung höchstens 0,01. Unter Abweichung ist die Wurzel aus der Summe der Quadrate der x- und y-Abweichungen der Farborte voneinander in der CIE-Normfarbtafel zu verstehen. Die laterale Ausdehnung der Abstrahlfläche ist hierbei bevorzugt größer als 1 cm, insbesondere größer als 10 cm.

Die homogene Abstrahlung der Mischstrahlung über die gesamte Abstrahlfläche ist unter anderem darüber erreicht, dass die von den Halbleiterchips der ersten und zweiten Gruppe emittierten Strahlung die Halbleiterchips der dritten Gruppe, mindestens zum Teil, durchläuft. Hierdurch findet eine effiziente Farbmischung auch innerhalb der Halbleiterchips der dritten Gruppe statt. Die Homogenität der Mischstrahlung ist somit auch bereits direkt an der Abstrahlfläche, die durch eine Hauptfläche der Halbleiterchips der dritten Gruppe gebildet sein kann, gewährleistet. Sind, anders als hier beschrieben, in verschiedenen Farben emittierende Halbleiterchips lateral nebeneinander angeordnet, so findet eine Mischung zu beispielsweise weißem Licht erst in einem gewissen Abstand von den Strahlung abstrahlenden Flächen der Halbleiterchips statt. Nahe an den Halbleiterchips ist somit keine homogene Abstrahlung erzielbar.

Gemäß zumindest einer Ausführungsform des Leuchtmittels ist dieses mechanisch flexibel gestaltet und ein Biegeradius von kleiner oder gleich 5 cm ist möglich. Die mechanische Flexibilität ist insbesondere durch die Verwendung von substratlosen Dünnfilmhalbleiterchips realisierbar. Durch die geringe Dicke solcher Bauteile treten bei moderatem Verbiegen nur geringe materialinterne mechanische Spannungen auf. Durch den schichtförmigen Aufbau, also dadurch, dass die Halbleiterchips der dritten Gruppe den Halbleiterchips der ersten und zweiten Gruppe bezüglich der Hauptabstrahlrichtung nachgeordnet sind, sind mechanische Verspannungen beim Biegen ebenfalls minimierbar. Dies gilt insbesondere, falls das optische Element, das sich zwischen den Halbleiterchips der ersten und zweiten Gruppe und dem mindestens einen Halbleiterchip der dritten Gruppe befindet, mit einer mechanisch flexiblen Folie gestaltet ist.

Gemäß zumindest einer Ausführungsform des Leuchtmittels ist das optische Element mit einer Kunststoff- und/oder einer Glasfolie gestaltet. Mit anderen Worten besteht das optische Element aus einer solchen Folie oder enthält eine derartige Folie.

Gemäß zumindest einer Ausführungsform des Leuchtmittels beträgt die Größe der Abstrahlfläche mindestens 1 cm², bevorzugt mindestens 10 cm², insbesondere mindestens 500 cm². Ein derartiges Leuchtmittel ist beispielsweise zur Hinterleuchtung von Displays einsetzbar.

Einige Anwendungsbereiche, in denen hier beschriebene Leuchtmittel Verwendung finden können, sind etwa die Hinterleuchtungen von Displays oder Anzeigeeinrichtungen. Weiterhin können die hier beschriebenen Leuchtmittel etwa auch in Beleuchtungseinrichtungen zu Projektionszwecken, in Scheinwerfern oder Lichtstrahlern oder auch bei der Allgemeinbeleuchtung eingesetzt werden.

Nachfolgend wird ein hier beschriebenes Leuchtmittel unter Bezugnahme auf die Zeichnung näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figur 1: eine schematische dreidimensionale Darstellung eines Ausführungsbeispiels eines hier beschriebenen Leuchtmittels,
- Figur 2: eine schematische dreidimensionale Darstellung eines weiteren Ausführungsbeispiels eines hier beschriebenen Leuchtmittels mit einem optischen Element,
- Figur 3: eine schematische Seitenansicht (A) und eine schematische dreidimensionale Darstellung (B) eines Beispiels eines hier beschriebenen Halbleiterchips mit einer Mikrostrukturierung,
- Figuren 4 und 6 bis 11: schematische Darstellungen von Anordnungen von Halbleiterchips von weiteren Ausführungsbeispielen von hier beschriebenen Leuchtmitteln,
- Figur 5: eine schematische Darstellungen einer nicht erfindungsgemäßen Abwandlung eines Leuchtmitteln,
- Figur 12: eine schematische Darstellung eines optischen Elements für hier beschriebene Leuchtmittel,
- Figuren 13 und 15: schematische Darstellungen von weiteren nicht erfindungsgemäßen Abwandlungen von Leuchtmitteln mit mindestens einem optischen Element, und
- Figur 14: eine schematische Darstellung eines weiteren Ausführungsbeispiels eines hier beschriebenen Leuchtmitteln mit mindestens einem optischen Element.

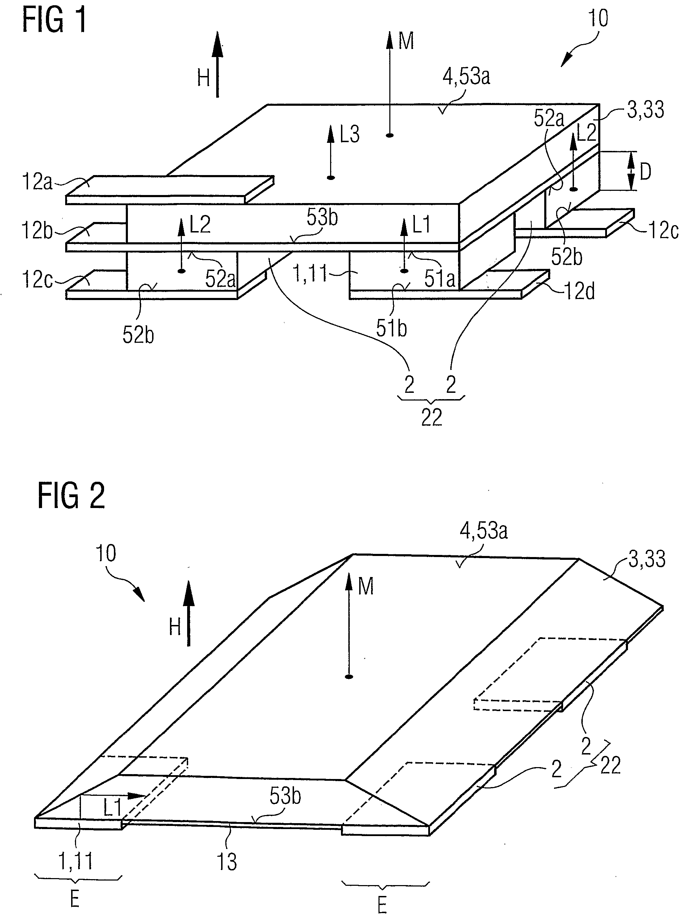

In Figur 1 ist ein Ausführungsbeispiel eines Leuchtmittels 10 dargestellt. Ein Halbleiterchip 1 einer ersten Gruppe 11 weist zwei einander gegenüberliegende Hauptseiten 51a, 51b auf. An der Hauptseite 51b, die einen Halbleiterchip 3 einer dritten Gruppe 33 abgewandt ist, ist ein elektrischer Anschluss 12d angebracht, der für eine im Betrieb des Halbleiterchips 1 emittierte Strahlung L1 reflektierend wirkt. Die Strahlung L1 umfasst einen Wellenlängenbereich im roten Spektralbereich.

Zwei Halbleiterchips 2 der zweiten Gruppe 22 sind analog zum Halbleiterchip 1 der ersten Gruppe 11 angeordnet und weisen zwei einander gegenüberliegende Hauptseite 52a, 52b auf, wobei an den Hauptseiten 52b elektrische Anschlüsse 12c angebracht sind, die für eine von den Halbleiterchips 2 im Betrieb emittierte Strahlung L2 reflektierend wirken. Die Strahlung L2 beinhaltet einen Wellenlängenbereich im grünen Spektralbereich. Die von den Halbleiterchips 1, 2 emittierte Strahlung L1, L2 ist durch Pfeillinien symbolisiert. Die Strahlung L1, L2 verlässt die Halbleiterchips 1, 2 durch die dem Halbleiterchip 3 der dritten Gruppe 33 zugewandten Hauptflächen 51a, 52a.

Eine Abstrahlfläche 4 des Leuchtmittels 10 ist durch eine Hauptfläche 53a des Halbleiterchips 3 der dritten Gruppe 33 gebildet. An einer der Abstrahlfläche 4 gegenüberliegenden Hauptseite 53b des Halbleiterchips 3 ist großflächig ein elektrischer Anschluss 12b angebracht. Der elektrische Anschluss 12b ist mit einem transparenten, leitfähigen Oxid, kurz TCO, gebildet. Über diesen elektrischen Anschluss 12b sind die Halbleiterchips 1, 2 der ersten 11 und zweiten Gruppe 22 mit dem Halbleiterchip 3 der dritten Gruppe 33 mechanisch, elektrisch und optisch verbunden. Der Halbleiterchip 3 der dritten Gruppe 33 ist weiterhin über einen elektrischen Anschluss 12a an der Hauptseite 53a elektrisch kontaktiert. Der elektrische Anschluss 12b kann für die Strahlung L1, L2 der Halbleiterchips 1, 2 transmittierend und für eine Strahlung L3 des Halbleiterchips 3 reflektierend wirken. Die vom Halbleiterchip 3 erzeugte Strahlung L3 weist einen Wellenlängenbereich im blauen Spektralbereich auf.

Die Strahlung L1, L2 der ersten Gruppe 11 und der zweiten Gruppe 22 mischt sich im Halbleiterchip 3 der dritten Gruppe 33 zu einer Mischstrahlung M, die über die Abstrahlfläche 4 das Leuchtmittel 10 verlässt. Somit ist eine Hauptabstrahlrichtung H des Leuchtmittels 10 senkrecht zur Abstrahlfläche 4 beziehungsweise zur Hauptfläche 53a orientiert. Die Hauptabstrahlrichtung H ist durch einen dick gezeichneten Pfeil symbolisiert. Hauptabstrahlrichtungen der Strahlungen L1, L2, L3 sind parallel zur Hauptabstrahlrichtung H des Leuchtmittels 10 ausgerichtet.

Der Halbleiterchip 3 der dritten Gruppe 33 überdeckt alle anderen Halbleiterchips 1, 2. Die Hauptflächen 51a, 51b, 52a, 52b, 53a, 53b der Halbleiterchips 1, 2, 3 sind parallel zueinander angeordnet und, im Rahmen der Herstellungstoleranzen, senkrecht zur Hauptabstrahlrichtung H orientiert. Die Halbleiterchips 1, 2, 3 weisen, im Rahmen der Herstellungstoleranzen, eine Dicke D von zirka 6 µm auf. Alle Halbleiterchips 1, 2, 3 sind elektrisch einzeln ansteuerbar. Hierdurch ist zum Beispiel die Farbe der Mischstrahlung M im Betrieb des Leuchtmittels 10 variierbar beziehungsweise einstellbar.

Ein weiteres Ausführungsbeispiel eines Leuchtmittels 10 ist in Figur 2 illustriert. Die Hauptfläche 53a des Halbleiterchips 3 der dritten Gruppe 33 ist kleiner als die Hauptfläche 53b. Hierdurch weist der Halbleiterchip 3 der dritten Gruppe 33 einen Randbereich E auf, in dem Seitenflächen des Halbleiterchips 3 abgeschrägt sind. Die Halbleiterchips 1, 2 der ersten 11 und zweiten Gruppe 22 sind in diesem Randbereich E an der Hauptfläche 53b angebracht. Durch die schrägen Seitenflächen wird die von den Halbleiterchips 1, 2 emittierte Strahlung L1, L2 in eine laterale Richtung senkrecht zur Hauptabstrahlrichtung H umgelenkt. Hierdurch erfolgt ein effizientes Mischen der Strahlungen L1, L2, L3 zur Mischstrahlung M im Halbleiterchip 3. Die Hauptfläche 53a bildet auch die Abstrahlfläche 4 des Leuchtmittels 10. An Teilbereichen der Hauptfläche 53b, die nicht in Kontakt zu den Halbleiterchips 1, 2 der ersten 11 und zweiten Gruppe 22 stehen, ist eine reflektierende Schicht 13 angebracht, durch die die Lichtauskopplung über die Abstrahlfläche 4 steigerbar ist.

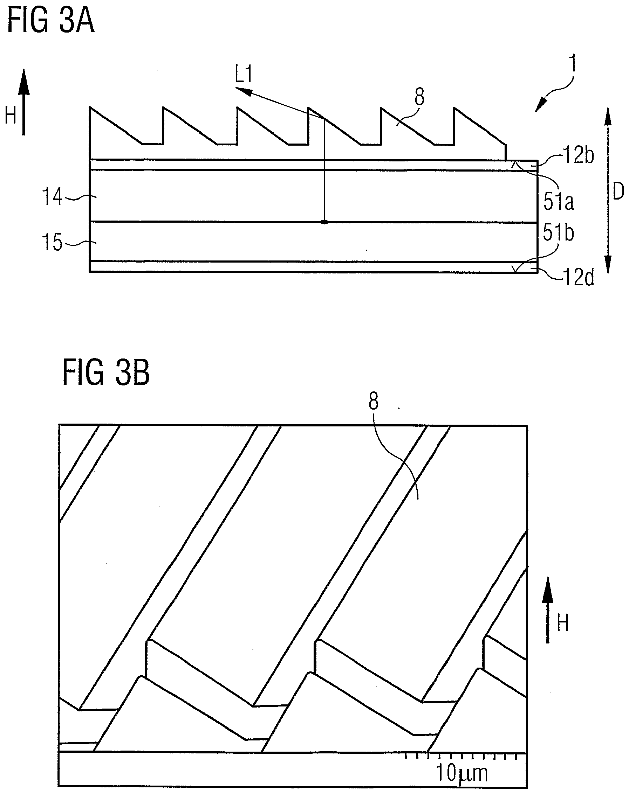

Ein Beispiel für Halbleiterchips 1, 2 insbesondere der ersten Gruppe 11 und der zweiten Gruppe 22 ist in Figur 3 gezeigt. Der Halbleiterchip 1 weist eine p-leitende Schicht 14 und eine n-leitende Schicht 15 auf. In einem Bereich, in dem die Schichten 14, 15 aufeinander treffen, ist ein pn-Übergang ausgebildet. In diesem Bereich wird die vom Halbleiterchip 1 zu emittierende Strahlung L1 im Betrieb erzeugt.

An der Hauptseite 51b befindet sich der elektrische Anschluss 12d, an der Hauptseite 51a der elektrische Anschluss 12b. An der den Schichten 14, 15 abgewandten Seite des Anschlusses 12b ist eine Mikrostruktur 8 mit einem dielektrischen Material aufgebracht. Die Mikrostruktur 8 weist eine prismenartige Struktur auf, siehe die schematische dreidimensionale Darstellung in Figur 3B. Über die zur Hauptfläche 51a schräg angeordneten Flächen der Mikrostruktur 8 wird die vom Halbleiterchip 1 erzeugte Strahlung L1 beispielsweise über Totalreflexion abgelenkt. Der Winkel der schräg angeordneten Fläche zur Hauptfläche 51a liegt bevorzugt im Bereich zwischen 30° und 60°, insbesondere bei zirka 45°. Zumindest zum Teil verläuft die Strahlung L1 in einer Richtung parallel zur Hauptfläche 51a und somit senkrecht zur Hauptabstrahlrichtung H. Samt Mikrostruktur 8 weist der Halbleiterchip 1 eine Dicke von zirka 18 µm auf.

Die Mikrostruktur 8 weist eine Strukturgröße von zirka 12 µm auf. Die Strukturgröße ist somit deutlich größer als die vom Halbleiterchip 1 emittierte Wellenlänge der Strahlung L1. Hierdurch lässt sich zum Beispiel das Auftreten von Beugungseffekte verringern. Zur Verbesserung der Auskoppeleffizienz der Strahlung L1 aus dem Halbleiterchip 1 ist der Anschluss 12d reflektierend für die Strahlung L1 ausgestaltet, der Anschluss 12b wirkt transmittierend bezüglich der Strahlung L1.

Ein Halbleiterchip 1 gemäß Figur 3A, 3B ist beispielsweise beim Ausführungsbeispiel gemäß Figur 2 einsetzbar, um eine effiziente Mischung der Strahlungen L1, L2, L3 im Halbleiterchip 3 der dritten Gruppe 33 zu erzielen.

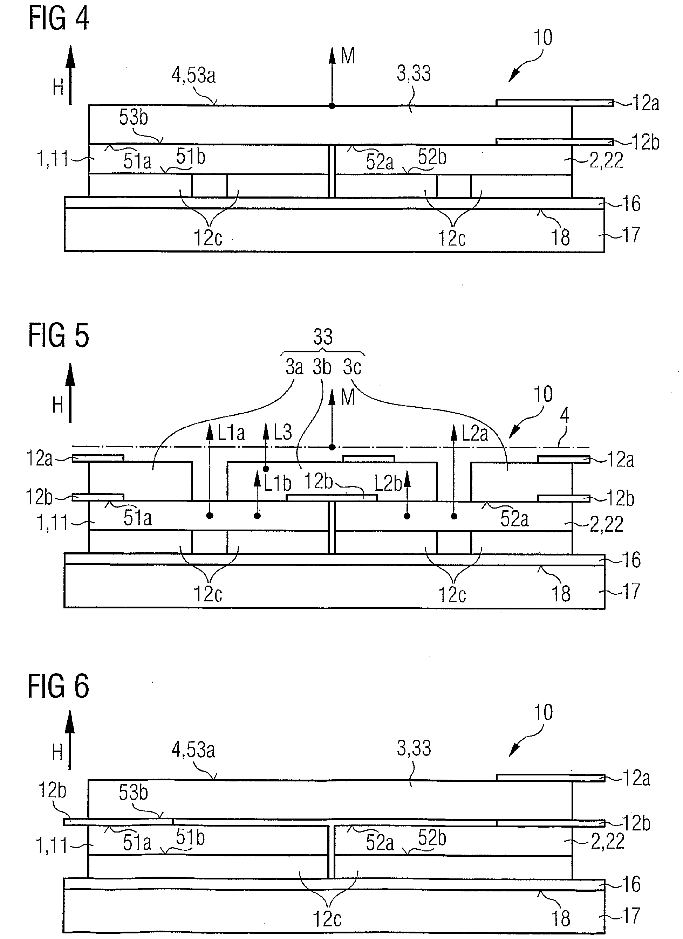

Verschiedene Anordnungen von Halbleiterchips 1, 2, 3 sind in den Figuren 4 bis 12 dargestellt.

Beim Ausführungsbeispiel des Leuchtmittels 10 gemäß Figur 4 sind an einer Trägeroberseite 18 eines Trägers 17 Leiterbahnen 16 angebracht. Der Träger 17 weist eine hohe Wärmeleitfähigkeit von bevorzugt mindestens 50 W/(m K) auf. Eine Dicke des Trägers 17 liegt zum Beispiel zwischen 50 µm und 300 µm. Der Träger 17 kann mit einem Metall, einer Keramik, einem Halbleitermaterial, einem Glas oder einem Kunststoff gestaltet sein.

Über die elektrischen Anschlüsse 12c sind die als Flip-Chips ausgestalteten Halbleiterchips 1, 2 der ersten 11 und zweiten Gruppe 22 elektrisch kontaktiert. Der Halbleiterchip 3 der dritten Gruppe 33 verfügt über separate elektrische Anschlüsse 12a, 12b. Hierdurch sind die Halbleiterchips 1, 2, 3 einzeln elektrisch ansteuerbar und bestrombar.

Der Halbleiterchip 3 überdeckt vollständig beide Halbleiterchips 1, 2 und schließt in einer Richtung senkrecht zur Hauptabstrahlrichtung H bündig mit den Halbleiterchips 1, 2 ab. Der Halbleiterchip 3 ist mit einem bezüglich der Wellenlänge der Strahlungen L1, L2 streuendem Material gestaltet, so dass im Halbleiterchip 3 eine effiziente Mischung der Strahlungen L1, L2, L3 stattfindet.

Sind die Halbleiterchips 1, 2, 3 als Dünnfilmchips mit einer Dicke von weniger als 20 µm gestaltet, so befinden sich alle Halbleiterchips 1, 2, 3, also auch der Halbleiterchip 3, sehr nahe am Träger 17. Hierdurch ist eine effiziente Abfuhr der im Betrieb der Halbleiterchips 1, 2, 3 entstehenden Wärme über den Träger 17 möglich. Die elektrischen Anschlüsse 12c sind bevorzugt großflächig ausgestaltet, wie auch die mit einem Metall gebildeten Leiterbahnen 16. Hierdurch ist der thermische Widerstand, insbesondere vom Halbleiterchip 3 zum Träger 17 hin, reduziert.

Bei der nicht erfindungsgemäßen Abwandlung gemäß Figur 5 sind mehrere Halbleiterchips 3 bezüglich der Hauptabstrahlrichtung H den Halbleiterchips 1, 2 der ersten 11 und der zweiten Gruppe 22 nachgeordnet. In den in lateraler Richtung mittleren Halbleiterchip 3 der dritten Gruppe 33 ist sowohl Strahlung L1 des Halbleiterchips 1 als auch Strahlung L2 des Halbleiterchips 2 eingekoppelt. Eine Teilstrahlung L1a, L2a ist nicht in die Halbleiterchips 3 geführt, sondern verlässt direkt das Leuchtmittel 10 durch die Abstrahlfläche 4, die durch eine Strichpunktlinie symbolisiert ist. Hierdurch kann die Farbe der Mischstrahlung M in einem großen Bereich der CIE-Normfarbtafel eingestellt werden.

Bei der Abwandlung gemäß Figur 5 sind die Halbleiterchips 1, 2 als Flip-Chips gestaltet. Beim Ausführungsbeispiel gemäß Figur 6 sind alle Halbleiterchips 1, 2, 3 so gestaltet, dass die elektrischen Anschlüsse 12a, 12b, 12c an den einander gegenüberliegenden Hauptseiten 51a, 51b, 52a, 52b, 53a, 53b liegen, so dass sich eine parallelartige elektrische Verschaltung ergibt. Die Anschlüsse 12b sind beispielsweise geerdet. Über die Leiterbahnen 16 und den Anschluss 12a können die Halbleiterchips 1, 2, 3 separat elektrisch angesteuert werden.

Optional können zwischen den Halbleiterchips 1, 2 und dem Halbleiterchip 3 auch nicht dargestellte dielektrische Zwischenschichten angebracht sein, die zur weiteren Lichtstreuung der Strahlung L1, L2 dienen können. Auch ist über solche dielektrischen Zwischenschichten im Falle einer Vielzahl von Halbleiterchips 1, 2, 3 eine vereinfachte elektrische Kontaktierung möglich.

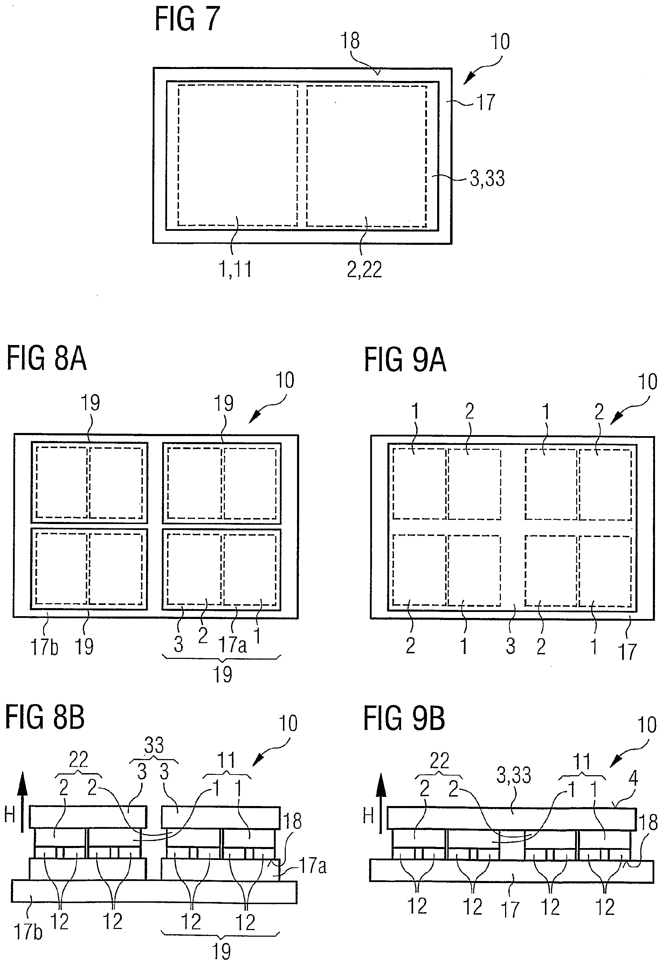

In Figur 7 ist eine schematische Draufsicht auf das Leuchtmittel gemäß Figur 6 gezeigt. Zur Vereinfachung der Darstellung sind die elektrischen Anschlüsse und die Leiterbahnen nicht gezeichnet.

Beim Ausführungsbeispiel gemäß Figur 8 sind die Halbleiterchips 1, 2, 3 in Modulen 19 angeordnet. Das Modul 19 ist beispielsweise wie das Leuchtmittel 10 gemäß Figur 4 gestaltet. Das Modul 19 weist einen Träger 17a auf, auf dessen Trägeroberseite 18 die Halbleiterchips 1, 2, 3 aufgebracht sind. Auf einem gemeinsamen Träger 17b sind dann mehrere Module 19, gemäß Draufsicht in Figur 8A in einer Anordnung von zwei mal zwei Modulen 19, angeordnet. Innerhalb eines Moduls 19 ist ein Halbleiterchip 1 der ersten Gruppe 11 und ein Halbleiterchip 2 der zweiten Gruppe 22 von einem einzigen Halbleiterchip 3 der dritten Gruppe 33 überdeckt.

Beim Ausführungsbeispiel gemäß Figur 9 sind mehrere Halbleiterchips 1 der ersten Gruppe 11 und mehrere Halbleiterchips 2 der zweiten Gruppe 22 von einem einzigen Halbleiterchip 3 der dritten Gruppe 33 überdeckt. Mehrere Leuchtmittel 10 gemäß Figur 9 können auf einem weiteren, nicht dargestellten Modulträger angeordnet sein. Zur Vereinfachung der Darstellung sind die elektrischen Anschlüsse in den Figuren 8 bis 14 nicht oder nur teilweise gezeichnet.

In einer lateralen Richtung schließt der Halbleiterchip 3 im Rahmen der Herstellungstoleranzen bündig mit den in lateraler Richtung am Rand des Leuchtmittels 10 liegenden Halbleiterchips 1, 2 ab. Die Halbleiterchips 1, 2 sind so angeordnet, dass in einer lateralen Richtung abwechselnd ein Halbleiterchip 1 der ersten Gruppe 11 auf einen Halbleiterchip 2 der zweiten Gruppe 22 folgt. Die Halbleiterchips 1, 2 sind auf dem Träger 17, wie in Figur 9A in der Draufsicht zu sehen ist, schachbrettartig angeordnet. Mit anderen Worten liegt eine wechselnde Abfolge von Halbleiterchips 1 der ersten Gruppe 11 und Halbleiterchips 2 der zweiten Gruppe 22 in beiden lateralen Hauptrichtungen vor.

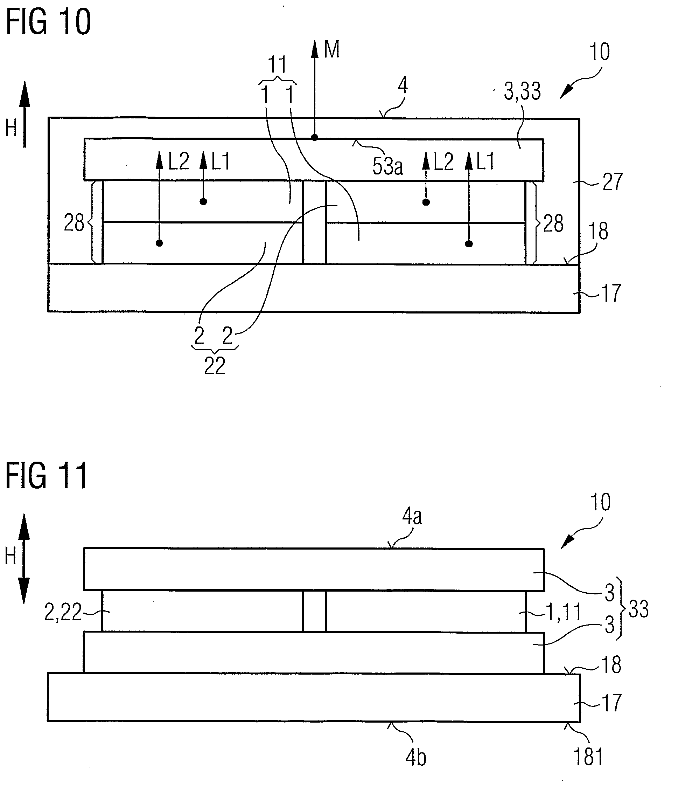

Beim Ausführungsbeispiel gemäß Figur 10 überragt der Halbleiterchip 3 der dritten Gruppe 33 die Halbleiterchips 1, 2 in einer lateralen Richtung. Zudem sind die Halbleiterchips 1, 2 bezüglich der Hauptabstrahlrichtung H in zwei Stapeln 28 angeordnet. Die Stapel 28 sind bezüglich dem Träger 17 abwechselnd orientiert, so dass in einem Stapel der Halbleiterchip 2 der Trägeroberseite 18 zugewandt ist, und im anderen Stapel der Halbleiterchip 1 der ersten Gruppe 11. Hierdurch erfolgt eine Mischung von der Strahlung L1 und der Strahlung L2 bereits in den dem Träger 17 abgewandten Halbleiterchips der Stapel 28. Hierdurch ist eine besonders homogene Abstrahlung über die Abstrahlfläche 4 des Leuchtmittels 10 erzielbar.

Optional sind die Halbleiterchips 1, 2, 3 von einer Verkapselung 27 umgeben. Die Verkapselung 27 kann an der Abstrahlfläche 4 eine Beschichtung oder eine Strukturierung aufweisen, die etwa die Lichtauskopplung aus dem Leuchtmittel 10 verbessert.

In Figur 11 ist ein Ausführungsbeispiel eines Leuchtmittels 10 dargestellt, bei dem zwischen zwei Halbleiterchips 3 der dritten Gruppe 33 die Halbleiterchips 1, 2 angebracht sind. Der Träger 17, auf dessen Trägeroberseite 18 sämtliche Halbleiterchips 1, 2, 3 angebracht sind, ist durchlässig für die von den Halbleiterchips 1, 2, 3 emittierte Strahlung. Hierdurch weist das Leuchtmittel 10 zwei Abstrahlflächen 4a, 4b auf. Die Abstrahlfläche 4b wird durch eine der Trägeroberseite 18 abgewandte Trägerunterseite 181 gebildet. Das Leuchtmittel 10 weist also zwei Hauptabstrahlrichtungen H auf, die in entgegengesetzte Richtungen weisen.

Der Träger 17 kann mit einer Kunststofffolie gestaltet sein. Wird eine Folie als Träger 17 verwendet, so kann das Leuchtmittel 10 mechanisch flexibel sein, das heißt, ein Biegeradius von 5 cm oder weniger ist realisierbar, ohne das Leuchtmittel 10 zu zerstören.

Mehrere der in Figur 11 dargestellten Einheiten von Halbleiterchips 1, 2, 3 können auf dem Träger 17 in einer oder auch in zwei lateralen Hauptrichtungen des Trägers 17 angebracht sein, so dass ein flächig abstrahlendes Leuchtmittel 10 realisierbar ist.

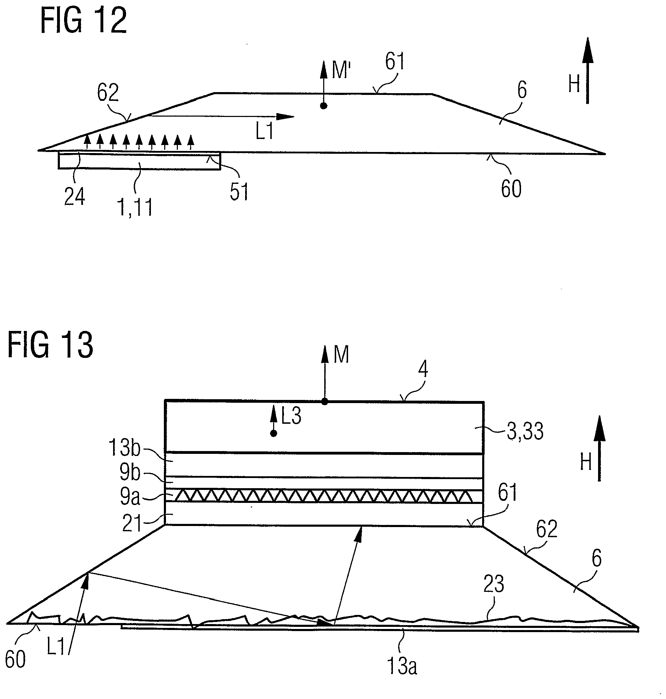

In Figur 12 ist ein optisches Element 6 dargestellt, wie es beispielsweise in Verbindung mit einem der Leuchtmittel gemäß der Figuren 1 bis 11 eingesetzt werden kann. An einer Elementunterseite 60 ist der Halbleiterchip 1 der ersten Gruppe 11 angebracht. Über die Hauptseite 51 in das optische Element 6 eingekoppelte Strahlung L1 wird über eine Schräge 62, die die Elementunterseite 60 mit einer Elementoberseite 61 verbindet, in eine Richtung senkrecht zur Hauptabstrahlrichtung H umgelenkt. Mit anderen Worten wird über das optische Element 6 die Richtung der Strahlung L1 des Halbleiterchips 1 im Wesentlichen um 90° gedreht. Entsprechendes gilt für einen in Figur 12 nicht gezeichneten Halbleiterchip der zweiten Gruppe. Hierdurch kann sich die Strahlung L1 des ersten Halbleiterchips und des zweiten Halbleiterchips im optischen Element 6 miteinander mischen. An der Elementoberseite 61 liegt also bereits eine Teilmischstrahlung vor, die über die Elementoberseite 61 homogen bezüglich Farbe und Intensität sein kann. Im auf der Elementoberseite 61 anzubringenden Halbleiterchip der dritten Gruppe, in Figur 12 nicht gezeichnet, erfolgt eine weitere Homogenisierung der Teilmischstrahlung und zudem ein Mischen mit der vom Halbleiterchip 3 der dritten Gruppe 33 erzeugten Strahlung.

Die Elementunterseite 60 weist gemäß Figur 12 eine kleinere Fläche auf als die Elementoberseite 61. Die Elementunterseite 60 kann als Montagefläche für alle Halbleiterchips 1, 2 der ersten 11 und zweiten Gruppe 22 dienen, die Elementoberseite 61 als Montagefläche für den mindestens einen Halbleiterchip 3 der dritten Gruppe 33. Das optische Element 6 ist hierbei als Pyramidenstumpf ausgebildet. Das optische Element 6 ist mit einer Glasfolie gebildet, die bevorzugt eine Dicke zwischen 30 µm und 300 µm aufweist.

Optional kann zwischen dem Halbleiterchip 1 und dem optischen Element 6 ein Koppelmedium 24 angebracht sein. Über das Koppelmedium 24 kann eine Haftvermittlung zwischen optischem Element 6 und Halbleiterchip 1 erfolgen. Außerdem kann das Koppelmedium 24 als Anpassung der Brechungsindices von Halbleiterchip 1 und optischem Element 6 dienen, so dass eine effiziente Einkopplung der Strahlung L1 in das optische Element 6 gewährleistet ist.

In Figur 13 ist eine nicht erfindungsgemäße Abwandlung des optischen Elements 6 gezeigt. An der Elementunterseite 60 weist das optische Element 6 eine reflektierende Schicht 13a auf, die in Bereichen angebracht ist, in denen sich keine, in Figur 13 nicht gezeichnete Halbleiterchips 1, 2 der ersten 11 und der zweiten Gruppe 22 befinden. An der Elementunterseite 60 ist weiterhin eine Aufrauung 23 erzeugt. Über diese Aufrauung kann eine Homogenisierung beispielsweise der Strahlung L1 erfolgen. Zur Umlenkung der Strahlung L1 weist das optische Element 6 die Schrägen 62 auf. An der Elementoberseite 61 ist eine Streuplatte 21 angebracht, die zu einer weiteren Homogenisierung der Strahlung der nicht gezeichneten Halbleiterchips 1, 2 dient. An einer dem optischen Element 6 abgewandten Hauptseite der Streuplatte 21 sind zwei gegeneinander um 90° rotierte Prismenfolien 9a, 9b angebracht.

Bezüglich der Hauptabstrahlrichtung H ist den Prismenfolien 9a, 9b eine weitere reflektierende Schicht 13b nachgeordnet. Die reflektierende Schicht 13b kann teilreflektierend bezüglich der von dem sich an der Elementunterseite 60 befindlichen Halbleiterchips 1, 2 sein. Die reflektierende Schicht 13b kann für die im Halbleiterchip 3 der dritten Gruppe 33 erzeugte Strahlung L3 reflektierend wirken, um die Auskoppeleffizienz der Strahlung L3 aus dem Leuchtmittel 10 zu erhöhen. Im Halbleiterchip 3 erfolgt eine weitere Streuung und Homogenisierung der von den Halbleiterchips 1, 2 emittierten Strahlungen L1, L2, so dass sich über Mischung im Halbleiterchip 3 die Mischstrahlung M ergibt.

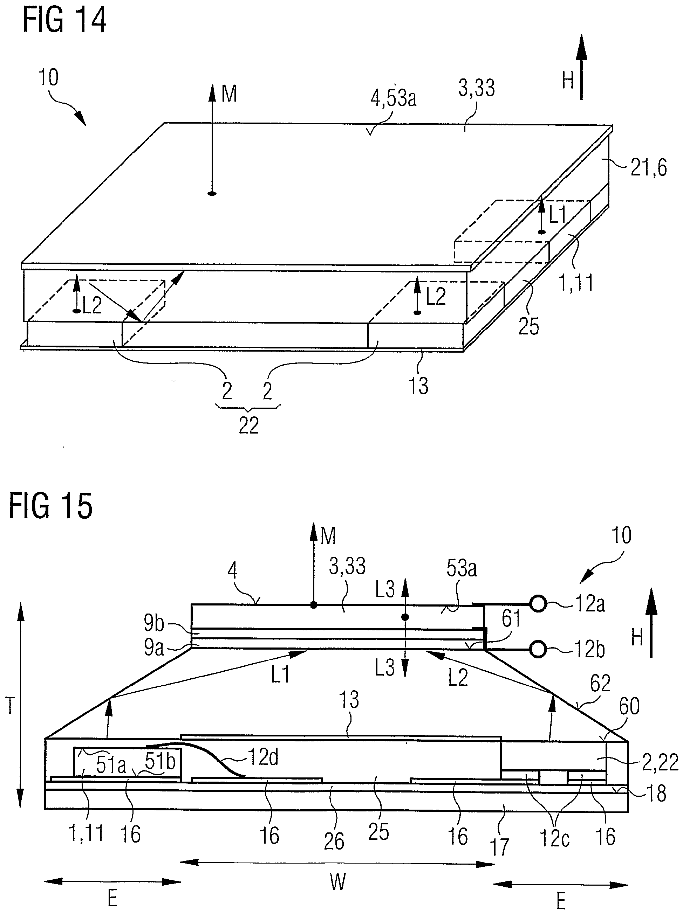

Beim Ausführungsbeispiel des Leuchtmittels 10 gemäß Figur 14, schematisch dreidimensional dargestellt, ist das optische Element 6, das sich zwischen den Halbleiterchips 1, 2 der ersten 11 und zweiten Gruppe 22 und dem Halbleiterchip 3 der dritten Gruppe 33 befindet, gleichzeitig als Streuplatte 21 gestaltet. Somit erfolgt über das optische Element 6 eine Führung und eine effiziente Homogenisierung der Strahlungen L1, L2. Die Abstrahlfläche 4 ist durch die Hauptseite 53a des Halbleiterchips 3 gebildet. In einer Richtung senkrecht zur Hauptabstrahlrichtung H befindet sich zwischen den Halbleiterchips 1, 2 ein Medium 25. Über dieses Medium 25 kann eine Haftvermittlung und Verkapselung der Halbleiterchips 1, 2 erfolgen. Das Medium 25 ist transparent oder, bevorzugt, streuend bezüglich der Strahlungen L1, L2 ausgestaltet. An dem optischen Element 6 abgewandten Seiten des Mediums 25 und der Halbleiterchips 1, 2 ist die reflektierende Schicht 13 angebracht, die reflektierend für die Strahlungen L1, L2, L3 wirkt.

Anders als in Figur 14 dargestellt, kann eine Vielzahl an Halbleiterchips 1 der ersten 11 und Halbleiterchips 2 der zweiten Gruppe 22 verwendet werden, um ein mit einer hohen Leistung intensiv und flächig abstrahlendes Leuchtmittel 10 zu erzielen.

In Figur 15 ist eine weitere nicht erfindungsgemäße Abwandlung gezeigt. Der Träger 17 ist metallisch gestaltet und weist eine hohe Wärmeleitfähigkeit auf. An der Trägeroberseite 18 ist eine Isolierschicht 26 aufgebracht, die die Leiterbahnen 16, die an der dem Träger 17 abgewandten Seite der Isolierschicht 26 aufgebracht sind, vom Träger 17 elektrisch isolieren. Über die Leiterbahnen 16 erfolgt eine elektrische Verschaltung der Halbleiterchips 1, 2.

Die Halbleiterchips 2 können als Flip-Chips ausgestaltet sein, so dass der Halbleiterchip 2 über elektrische Anschlüsse 12c kontaktiert wird, die beide dem Träger 17 zugewandt sind. Bezüglich des Halbleiterchips 1 ist gezeigt, dass dieser elektrische Kontakte an der dem Träger 17 zugewandten Hauptseite 51b und der dem Träger abgewandten Hauptseite 51a aufweist. Die Hauptseite 51a ist elektrisch über einen Bonddraht 12d mit der Leiterbahn 16 verbunden. Die Halbleiterchips 1, 2 können auch auf eine gleiche Weise, beispielsweise jeweils über Bond-Drähte 12d, elektrisch kontaktiert sein. Dies ist der bevorzugte Fall.

Das Medium 25 verkapselt und isoliert die Halbleiterchips 1, 2 und die elektrischen Anschlüsse 12c, d sowie Leiterbahnen 16. Über das Medium 25 sind die Halbleiterchips 1, 2 mit dem optischen Element 6 verbunden, das Schrägen 62 aufweist. An der Elementunterseite 60 ist in den Teilbereichen, in dem sich keine Halbleiterchips 1, 2 befinden, die reflektierende Schicht 13 aufgebracht. Zwischen der Elementoberseite 61 und dem Halbleiterchip 3 der dritten Gruppe 33 sind die zwei Prismenfolien 9a, 9b angebracht. Der Halbleiterchip 3 ist über die elektrischen Anschlüsse 12a, 12b elektrisch kontaktiert.

Der Halbleiterchip 3 emittiert die Strahlung L3 beidseitig sowohl in eine Richtung vom optischen Element 6 weg als auch in eine Richtung zum optischen Element 6 hin. Die Leiterbahnen 16 wirken reflektierend bezüglich der Strahlungen L1, L2, L3.

Die Halbleiterchips 1, 2 befinden sich in den Randbereichen E, in denen das optische Element 6 die Schrägen 62 aufweist. Die Randbereiche E haben, in einer Richtung senkrecht zur Hauptabstrahlrichtung H, eine Ausdehnung in der Größenordnung von 500 µm. Eine Zentralbreite W, die im Wesentlichen der lateralen Ausdehnung der Elementoberseite 61 entspricht, beträgt einige cm bis einige m. Eine Ausdehnung des Mediums 25 in Richtung der Hauptabstrahlrichtung H beträgt zirka 100 µm, eine Ausdehnung des optischen Element 6 sowie der Prismenfolien 9a, 9b, der elektrischen Anschlüsse 12a, 12b und des Halbleiterchips 3 der dritten Gruppe 33 in Richtung der Hauptabstrahlrichtung H beträgt zirka 500 µm. Somit liegt eine vertikale Ausdehnung T des Leuchtmittels 10, in Richtung der Hauptabstrahlrichtung H, inklusive dem Träger 17, bei zirka 700 µm. Das Verhältnis aus Zentralbreite W und vertikaler Ausdehnung T beträgt also mindestens 100, insbesondere mindestens 1000. Die von der Hauptseite 53a gebildete Abstrahlfläche 4 des Leuchtmittels 10 weist eine Fläche von wenigstens einigen cm² auf.

An der Hauptfläche 53a des Halbleiterchips 3 kann optional eine Schutzschicht aufgebracht sein, in Figur 15 nicht dargestellt, die den Halbleiterchip 3 vor mechanischen Belastungen und Umwelteinflüssen wie beispielsweise Feuchte schützt. Die Schutzschicht kann auch optisch wirken, zum Beispiel als Antireflexschicht. Es ist möglich, dass der Träger 17 als Metallfolie gestaltet ist, so dass das Leuchtmittel 10 mechanisch flexibel ist.

## Patentansprüche

1. Leuchtmittel (10) mit
- einer ersten Gruppe (11) von Halbleiterchips (1) und einer zweite Gruppe (22) von Halbleiterchips (2), die jeweils mindestens einen Halbleiterchip (1, 2) umfassen, wobei die erste (11) und die zweite Gruppe (22) von Halbleiterchips (1, 2) wenigstens zum Teil bezüglich einer Hauptabstrahlrichtung (H) des Leuchtmittels (10) lateral nebeneinander angeordnet sind,
- einer dritten Gruppe (33) von Halbleiterchips (3), die mindestens einen Halbleiterchip (3) umfasst, und die dritte Gruppe (33) bezüglich der Hauptabstrahlrichtung (H) der ersten (11) und der zweiten Gruppe (22) nachgeordnet ist,
wobei
- jede Gruppe (11, 22, 33) von Halbleiterchips (1, 2, 3) dazu ausgestaltet ist, in paarweise voneinander verschiedenen Wellenlängenbereichen elektromagnetische Strahlung (L1, L2, L3) zu emittieren, und
- von einer Abstrahlfläche (4) des Leuchtmittels (10) eine Mischstrahlung (M) emittiert wird,
und wobei
- die von der dritten Gruppe (33) von Halbleiterchips (3) emittierte Strahlung den kurzwelligsten Wellenlängenbereich (L3) aufweist,
- die von der ersten (11) und zweiten Gruppe (22) von Halbleiterchips (1, 2) emittierte Strahlung wenigstens teilweise in den wenigstens einen Halbleiterchip (3) der dritten Gruppe (33) gelangt, und
- der wenigstens eine Halbleiterchip (1, 2) der ersten (11) und der zweiten Gruppe (22), in der Hauptabstrahlrichtung (H) gesehen, vollständig vom wenigstens einen Halbleiterchip (3) der dritten Gruppe (33) überdeckt ist.

2. Leuchtmittel (10) nach Anspruch 1,
bei dem eine Hauptfläche (53) des mindestens einen Halbleiterchips (3) der dritten Gruppe (33) größer ist als eine Hauptfläche (51, 52) des mindestens einen Halbleiterchips (1, 2) der ersten (11) und der zweiten Gruppe (22).

3. Leuchtmittel (10) nach Anspruch 1 oder 2,
bei dem mindestens ein Halbleiterchip (1, 2, 3) eine Dicke (D) aufweist, die kleiner oder gleich 20 µm ist.

4. Leuchtmittel (10) nach einem der vorhergehenden Ansprüche,
bei dem jede Gruppe (11, 22, 33) von Halbleiterchips (1, 2, 3) elektrisch einzeln ansteuerbar ist.

5. Leuchtmittel (10) nach einem der vorhergehenden Ansprüche,
bei dem zumindest ein Halbleiterchip (1, 2) der ersten (11) und der zweiten Gruppe (22) als Flip-Chip gestaltet ist und bei dem zumindest ein Halbleiterchip (3) der dritten Gruppe (33) elektrische Kontakte auf den einander gegenüberliegenden Hauptflächen (53) aufweist.

6. Leuchtmittel (10) nach einem der vorhergehenden Ansprüche,
bei dem die erste (11) und die zweite Gruppe (22) jeweils wenigstens zwei Halbleiterchips (1, 2) umfasst, wobei wenigstens ein Halbleiterchip (1) der ersten Gruppe (11) und wenigstens ein Halbleiterchip (2) der zweiten Gruppe (22) bezüglich der Hauptabstrahlrichtung (H) übereinander angeordnet sind.

7. Leuchtmittel (10) nach einem der vorhergehenden Ansprüche,
bei dem zumindest ein Halbleiterchip (1, 2, 3) prismenartige Mikrostrukturen (8) aufweist.

8. Leuchtmittel (10) nach einem der vorhergehenden Ansprüche,
das mechanisch flexibel gestaltet und ein Biegeradius ≤ 5 cm möglich ist.

## Claims

1. An luminous means (10) comprising
- a first group (11) of semiconductor chips (1) and a second group (22) of semiconductor chips (2) which each comprise at least one semiconductor chip (1, 2), wherein the first (11) and the second group (22) of semiconductor chips (1, 2) are arranged at least partially laterally next to one another with respect to a main emission direction (H) of the luminous means (10),
- a third group (33) of semiconductor chips (3) which comprises at least one semiconductor chip (3), and the third group (33) follows the first group (11) and the second group (22) with respect to the main emission direction (H), wherein
- each group of semiconductor chips (1, 2, 3) is designed to emit electromagnetic radiation (L1, L2, L3) in wavelength ranges different from each other in pairs, and
- a mixed radiation (M) is emitted from an emission surface (4) of the luminous means (10),
and wherein
- the radiation emitted by the third group (33) of semiconductor chips (3) has the shortest wavelength range (L3),
- the radiation emitted by the first (11) and the second group (22) of semiconductor chips (1, 2) passes at least partially into the at least one semiconductor chip (3) of the third group (33), and
- the at least one semiconductor chip (1, 2) of the first (11) and of the second group (22), seen along the main emission direction (H), is completely covered by the at least one semiconductor chip (3) of the third group (33).

2. The luminous means (10) according to claim 1,
in which a main surface (53) of the at least one semiconductor chip (3) of the third group (33) is larger than a main surface (51, 52) of the at least one semiconductor chip (1, 2) of the first (11) and of the second group (22).

3. The luminous means (10) according to claim 1 or 2,
in which at least one semiconductor chip (1, 2, 3) has a thickness (D) which is smaller than or equal to 20 µm.

4. The illuminant means (10) according to one of the preceding claims,
in which each group of semiconductor chips (1, 2, 3) can be electrically controlled individually.

5. The luminous means (10) according to one of the preceding claims,
in which at least one semiconductor chip (1, 2) of the first (11) and of the second group (22) is designed as a flip-chip and in which at least one semiconductor chip (3) of the third group (33) has electrical contacts on opposing main surfaces (53) .

6. The luminous means (10) according to one of the preceding claims,
in which the first group (11) and the second group (22) each comprise at least two semiconductor chips (1, 2),
wherein at least one semiconductor chip (1) of the first group (11) and at least one semiconductor chip (2) of the second group (22) are arranged one above the other with respect to the main emission direction (H).

7. The luminous means (10) according to one of the preceding claims,
in which at least one semiconductor chip (1, 2, 3) has prism-like microstructures (8).

8. The luminous means (10) according to one of the preceding claims,
which is of mechanically flexible design and a bending radius of ≤ 5 cm is possible.

## Revendications

1. Illuminant (10) comprenant
- un premier groupe (11) de puces semi-conductrices (1) et un deuxième groupe (22) de puces semi-conductrices (2) comprenant chacun au moins une puce semi-conductrice (1, 2), le premier (11) et le deuxième groupe (22) de puces semi-conductrices (1, 2) étant disposés au moins partiellement de façon latérale l'un à côté de l'autre par rapport à une direction d'émission principale (H) de l'illuminant (10),
- un troisième groupe (33) de puces semi-conductrices (3) comportant au moins une puce semi-conductrice (3), le troisième groupe (33) étant disposé en aval du premier groupe (11) et du deuxième groupe (22) par rapport à la direction d'émission principale (H),
- chaque groupe (11, 22, 33) de puces semi-conductrices (1, 2, 3) étant configuré pour émettre un rayonnement électromagnétique (L1, L2, L3) dans des gammes de longueurs d'onde différentes par paires les unes des autres, et
- un rayonnement mixte (M) étant émise à partir d'une surface rayonnante (4) de l'illuminant,
et
- le rayonnement émis par le troisième groupe (33) de puces semi-conductrices (3) présentant la gamme de longueur d'onde (L3) la plus courte,
- le rayonnement émis par le premier groupe (11) et le deuxième groupe (22) de puces semi-conductrices (1, 2) parvenant au moins partiellement dans l'au moins une puce semi-conductrice (3) du troisième groupe (33), et
- l'au moins une puce semi-conductrice (1, 2) des premier (11) et deuxième (22) groupes, vu en direction d'émission principale (H), est recouverte entièrement par l'au moins une puce semi-conductrice (3) du troisième groupe (33).

2. Illuminant (10) selon la revendication 1, dans lequel une surface principale (53) de l'au moins une puce semi-conductrice (3) du troisième groupe (33) est plus grande qu'une surface principale (51, 52) de l'au moins une puce semi-conductrice (1, 2) des premier (11) et deuxième (22) groupes.

3. Illuminant (10) selon la revendication 1 ou 2, dans lequel au moins une puce semi-conductrice (1, 2, 3) présente une épaisseur (D) inférieure ou égale à 20 µm.

4. Illuminant (10) selon l'une des revendications précédentes, dans lequel chaque groupe (11, 22, 33) de puces semi-conductrices (1, 2, 3) est susceptible d'être excité électriquement de façon indépendante.

5. Illuminant (10) selon l'une des revendications précédentes, dans lequel au moins une puce semi-conductrice (1, 2) des premier (11) et deuxième (22) groupes est conçue sous forme d'une puce type flip-chip et dans lequel au moins une puce semi-conductrice (3) du troisième groupe (33) présente des contacts électriques sur les surfaces principales (53) disposées en vis-à-vis l'une par rapport à l'autre.

6. Illuminant (10) selon l'une des revendications précédentes, dans lequel les premier (11) et deuxième (22) groupes comprennent chacun au moins deux puces semi-conductrices (1, 2), au moins une puce semi-conductrice (1) du premier groupe (11) et au moins une puce semi-conductrice (2) du deuxième groupe (22) sont disposées l'une au dessus de l'autre par rapport à la direction d'émission principale (H).

7. Illuminant (10) selon l'une des revendications précédentes, dans lequel au moins une puce semi-conductrice (1, 2, 3) présente des microstructures prismatiques (8).

8. Illuminant (10) selon l'une des revendications précédentes, conçu de façon mécaniquement flexible, un rayon de courbure ≤ 5 cm étant possible.
